(19) **Europäisches Patentamt**

**European Patent Office**

**Office européen des brevets**

(11) **EP 0 364 830 B2**

(12) **NEUE EUROPÄISCHE PATENTSCHRIFT**

(45) Veröffentlichungstag und Bekanntmachung des Hinweises auf die Entscheidung über den Einspruch:
**18.10.2000  Patentblatt 2000/42**

(51) Int. Cl.[7]: **H03H 11/12**

(45) Hinweis auf die Patenterteilung:
**10.08.1994  Patentblatt 1994/32**

(21) Anmeldenummer: **89118550.6**

(22) Anmeldetag: **06.10.1989**

(54) **RC-Tiefpassschaltung**

RC low-pass circuit

Circuit RC-passe-bas

(84) Benannte Vertragsstaaten:
**DE FR GB IT NL**

(30) Priorität: **18.10.1988 DE 3835378**

(43) Veröffentlichungstag der Anmeldung:
**25.04.1990  Patentblatt 1990/17**

(73) Patentinhaber:
**TEMIC TELEFUNKEN microelectronic GmbH
90411 Nürnberg (DE)**

(72) Erfinder: **Siegle, Martin
D-7100 Heilbronn-Frankenbach (DE)**

(74) Vertreter:
**Maute, Hans-Jürgen, Dipl.-Ing.
TEMIC TELEFUNKEN microelectronic GmbH
Postfach 35 35
74025 Heilbronn (DE)**

(56) Entgegenhaltungen:
**EP-A- 0 123 909          DE-B- 1 141 338
US-A- 4 775 829**

• **PATENT ABSTRACTS OF JAPAN, Band 4, Nr. 5 (E-165) 16. Januar 1980 & JP-A-54 146 545**
• **Bipolar and MOS Analog Integrated Circuit Design; Allan B. Grebene, John Wiley & Sons, 1984 Seiten:V, 142,143,172,173**

**EP 0 364 830 B2**

## Beschreibung

Die Erfindung bezieht sich auf eine RC-Tiefpaßschaltung gemäß den Merkmalen des Anspruchs.

Aus der US PS 4 775 829 ist eine Spannungsstabilisierungsschaltung mit einem Stromspiegel, an dessen Ausgängen eine Vielzahl von Konstantströmen der integrierten Schaltung zur Verfügung gestellt wird bekannt. Es wird dazu eine RC-Tiefpaßschaltung verwendet, bei der der Eingang über den Widerstand und den Kondensator des RC-Gliedes mit dem Bezugspunkt verbundenen ist. Am Verbindungspunkt von Kondensator und Widerstand des RC-Gliedes ist der Stromspiegel angeschlossen, welcher den Ausgangsstrom der Schaltung entsprechend seinem Stromspiegelverhältnis vergrößert.

Aufgabe der Erfindung ist es einerseits eine große RC Konstante des Tiefpaßgliedes zu ermöglichen und gleichzeitig damit eine Mittenpunktspannung zu erzeugen. Diese Aufgabe wird bei einer RC-Tiefpaßschaltung nach der Erfindung durch die kennzeichnenden Merkmale des Anspruchs gelöst.

Die Erfindung wird im folgenden an Ausführungsbeispielen erläutert.

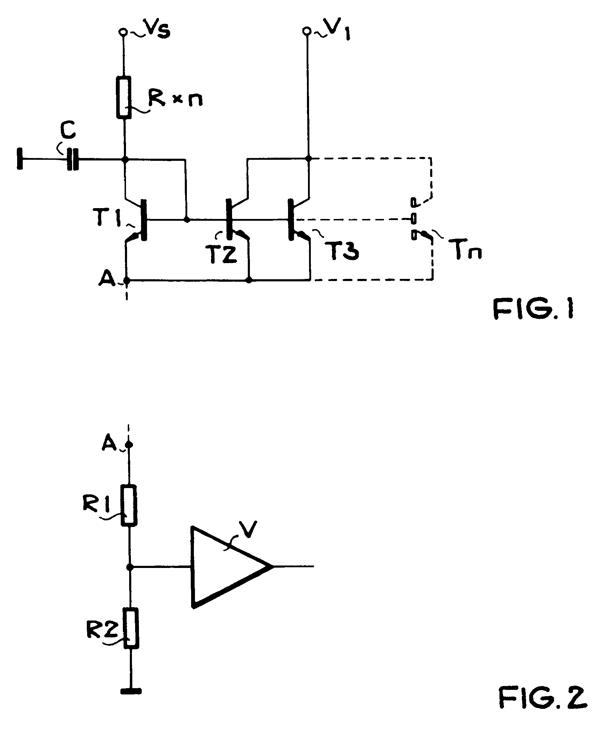

Die Figur 1 zeigt eine Schaltung mit einem RC-Glied und einem Stromspiegel. Bei dieser Schaltung ist der Eingang $V_s$ über den Widerstand $R*n$ und den Kondensator C mit dem Bezugspunkt verbunden. Am Verbindungspunkt von Widerstand $R*n$ und Kondensator C ist ein Stromspiegel angeschlossen, der aus den Transistoren $T_1 ... T_n$ besteht. Der Widerstand des RC-Gliedes ist deshalb mit $R*n$ bezeichnet, weil bei Verwendung eines Stromspiegels mit der n-fachen Emitterfläche der Stromspiegeltransistoren gegenüber der Emitterfläche von nur einem Transistor (ohne Stromspiegel) der Widerstand des RC-Gliedes n mal größer gemacht werden kann, als ohne Stromspiegel. Dies gilt für gleichen Lastwiderstand. Wird der Widerstand des RC-Gliedes bei Verwendung eines Stromspiegels n mal größer gemacht als ohne Stromspiegel, so erhöht sich die Zeitkonstante des RC-Gliedes entsprechend. Die Größe n drückt das Stromspiegelverhältnis eines Stromspiegels aus, d.h. das Verhältnis der Summe der Emitterflächen von n Spiegeltransistoren zur Emitterfläche von nur einem Transistor (bei Verzicht auf einen Stromspiegel). Der Ausgang der Schaltung der Figur 1 ist mit A bezeichnet. Zwischen den Ausgang A und den Bezugspunkt ist im allgemeinen ein Lastwiderstand geschaltet, der in Figur 1 nicht eingezeichnet ist. $V_1$ ist meistens mit Vs identisch.

Die Erhöhung des Ausgangsstromes bzw. die Verringerung des Lastwiderstandes am Ausgang A kann weitgehend unabhängig vom RC-Glied sowie der Ausgangsspannung an A eingestellt werden. Bei vorgegebenem Lastwiderstand und Ausgangsspannung kann der Widerstand $R*n$ entsprechend dem Spiegelverhältnis vergrößert werden und damit auch die Zeitkonstante des R-C-Gliedes.

Bei der Schaltung der Figur 2 ist als Lastwiderstand der Schaltung der Figur 1 ein Spannungsteiler mit den Widerständen $R_1$ und $R_2$ vorgesehen. Der Spannungsteiler R1, R2 dient im Beispiel der Figur 2 zur Mittenpunkt-Spannungserzeugung eines NF-Verstärkers V. Das RC-Glied bewirkt bei der Schaltung der Figur 2 eine Brummunterdrückung. Auch bei der Schaltung der Figur 2 ist durch den Stromspiegel eine Erhöhung der Zeitkonstante des RC-Gliedes (ohne Veränderung der Widerstände $R_1$ und $R_2$) möglich. Die Widerstände $R_1$ und $R_2$ des Spannungsteilers werden vorzugsweise so bemessen, daß $R_1 + R_2 > R*n$ ist.

## Patentansprüche

1. RC-Tiefpaßschaltung mit einem über den Widerstand und den Kondensator des PC-Gliedes mit dem Bezugspunkt verbundenen Eingang, wobei am Verbindungspunkt von Kondensator und Widerstand des RC-Gliedes ein Stromspiegel angeschlossen ist, welcher den Ausgangsstrom der Schaltung entsprechend seinem Stromspiegelverhältnis vergrößert,
dadurch gekennzeichnet,

    daß die Emitter der Stromspiegeltransistoren den Ausgang der Schaltung bilden und
    daß am Ausgang der Schaltung ein Widerstandsteiler angeschlossen ist der einen Verstärker mit der Mittenspannung versorgt.

## Claims

1. A low-pass RC circuit with an input connected to the reference point via the resistor and the capacitor of the RC element, a current mirror being connected to the connection point of capacitor and resistor of the RC element, the current mirror increasing the output current of the circuit according to its current mirror ratio,
characterised in that;

    the emitters of the current mirror transistors form the output of the circuit and in that;
    there is connected to the output of the circuit a resistance divider, which provides an amplifier with the centre voltage.

## Revendications

1. Circuit de filtre passe-bas RC comportant une entrée reliée au point de référence par l'intermédiaire de la résistance et du condensateur du circuit RC, et dans lequel au point de liaison du condensateur et de la résistance du circuit RC est raccordé un miroir de courant, qui modifie le courant de sortie du circuit en fonction du rapport du miroir de courant,

caractérisé en ce

que les émetteurs des transistors du miroir de courant forment la sortie du circuit, et qu'à la sortie du circuit est raccordé un diviseur à résistances, qui alimente un amplificateur avec la tension médiane.

FIG.1

FIG.2